(19) **Europäisches Patentamt**

**European Patent Office**

**Office européen des brevets**

(11) Publication number: **0 070 744**
**B1**

(12) **EUROPEAN PATENT SPECIFICATION**

(45) Date of publication of patent specification: **26.03.86**

(21) Application number: **82303890.6**

(22) Date of filing: **22.07.82**

(51) Int. Cl.⁴: **H 01 L 29/78,** H 01 L 29/08, H 01 L 29/10

(54) **Insulated gate field effect transistor.**

(30) Priority: **22.07.81 JP 113692/81**

(43) Date of publication of application:
**26.01.83 Bulletin 83/04**

(45) Publication of the grant of the patent:
**26.03.86 Bulletin 86/13**

(84) Designated Contracting States:
**DE FR GB NL**

(56) References cited:
**EP-A-0 006 428**
**US-A-3 615 938**
**US-A-3 916 430**
**US-A-3 983 620**
**US-A-4 039 869**

**IBM Technical Disclosure Bulletin, vol. 6, no. 9, Febr. 1964, pages 91-93**

(73) Proprietor: **Hitachi, Ltd.**
**5-1, Marunouchi 1-chome**
**Chiyoda-ku Tokyo 100 (JP)**

(72) Inventor: **Sakai, Yoshio**
**1-47-2-E304, Akatsuki-cho**
**Hachioji-shi Tokyo (JP)**
Inventor: **Funabashi, Tsuneo**
**2-32-D308, Koyasu-cho**
**Hachioji-shi Tokyo (JP)**

(74) Representative: **Calderbank, Thomas Roger et al**
**MEWBURN ELLIS & CO. 2/3 Cursitor Street**
**London EC4A 1BQ (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

The present invention relates to an insulated gate field effect transistor (hereinafter referred to as a MOS transistor).

A standard MOS transistor has source and drain regions of one semiconductor type in a substrate of a second semiconductor type. The source and drain regions extend from the surface of the substrate and an insulating layer of, for example, an oxide is on the surface of the substrate between the source and drain regions. A gate electrode is formed on the insulating layer.

The part of the substrate between the source and drain regions is known as the channel and if a positive voltage is applied to the gate electrode of an n-channel device, a depletion layer is formed in the channel. As the gate bias increases, the depletion layer spreads into the substrate.

It is known that when a depletion-mode MOS transistor is operated with the gate and source connected in common, current passing from the drain to the source exhibits a constant current characteristic. The E/D MOS circuit utilizes this fact. The circuit has already been reported in 'IBM Technical Disclosure Bulletin', Vol. 6 No. 9, Feb. 1964, pp. 91—92. An E/D MOS inverter which is a basic circuit of the E/D MOS circuit consists of an enhancement-mode MOS transistor to function as a driver, the source of which is grounded, and a depletion-mode MOS transistor to function as a load, the drain of which is connected to a power source and the gate and source of which are short-circuited. The common end of that short circuit is connected to the drain of the driver MOS transistor, the connection point serving as an output terminal, while the gate of the driver MOS transistor serves as an input terminal.

It has been suggested that the E/D MOS inverter has high switching speed owing to the constant current characteristic of the load current which flows through the depletion-mode MOS transistor. It has therefore been proposed as the fundamental circuit for logic LSIs of low power dissipation and high operating speed.

However, where such an E/D MOS circuit is fabricated as an integrated circuit, i.e. the transistors on the same chip, the depletion-mode MOS transistor and the enhancement-mode MOS transistor are formed with a common substrate. The substrate is usually earthed, so that a potential difference arises between the source and substrate of the depletion-mode MOS transistor, resulting in a phenomenon known as the body effect. As an example of this, when the driver of the E/D MOS inverter turns "off" the source—substrate potential difference of the depletion-mode MOS transistor gradually increases to raise the threshold voltage of this transistor and thereby lower its conductance.

Therefore, the charging current to stray capacitance coupled to the output terminal decreases. Thus, the body effect reduces the load current, which prevents the E/D MOS circuit from operating at high speed.

An insulated gate field effect transistor as known from EP—A 0 006 428 in which the source and drain regions are formed in a well region of opposite conductivity type, which well region is formed in a substrate of the same conductivity type as the source and drain regions. The source and drain regions are exposed at a surface of the semiconductor body in which they are formed, and there is an insulating layer on the substrate which extends between the source and drain regions. There is also a gate electrode on the insulating layer. Thus this document corresponds to the pre-characterising part of claim 1. Again, however, there will be a body effect which prevents the device from operating at high speed.

The present invention seeks to provide an insulating gate field effect transistor in which the body effect is small, so that a constant current characteristic may be achieved. This is done by providing an opening in the well region reaching the surface between the source and drain regions, which opening contains semiconductor material of the same conductivity type as the substrate, indeed may be a part of the substrate.

The source and drain regions may be enclosed within the well region in the substrate, so that there is no direct contact between the source and drain regions and the material in the opening. However, it is preferable that the source and drain regions are contiguous with at least that part of the material lying between them in the opening.

The transistor is operated by applying a bias voltage which reverse-biases the junction between the well region and the substrate, and owing to which the whole or a part of the opening becomes a depletion layer. Accordingly, a thick depletion layer exists in the active region of the transistor opposing the gate electrode, so that the threshold voltage of the transistor does not fluctuate in dependence upon the source potential. Thus, the field effect transistor of small body effect is provided.

The field effect transistor of the present invention is suitable for use in a monolithic logic integrated circuit. It may be readily formed in the same chip as a CMOS circuit.

Embodiments of the present invention will now be described, by way of example, with reference to the accompanying drawings, in which:

Figures 1A and 1B are a sectional view and a plan view of an embodiment of the present invention, respectively.

Figure 2A is a graph showing the load current characteristic of the embodiment.

Figure 2B is a diagram of a circuit for measuring the characteristic in Figure 2A.

Figures 3 and 4 are plan views each showing another embodiment.

Figures 5A and 5B are a sectional view and an equivalent circuit diagram of still another embodiment, respectively.

Figures 6 and 7 are sectional views each showing a further embodiment.

Figures 8A to 8F are sectional views showing the manufacturing steps of a further embodiment.

Figures 9A to 9C are sectional views showing different manufacturing steps which can replace some of the aforementioned manufacturing steps.

Figures 10A to 10C are sectional views showing still different manufacturing steps.

Figures 11A and 11B are an equivalent circuit diagram and a sectional view of an embodiment of an inverter circuit which employs the transistor of the present invention, respectively.

Figure 11C is an equivalent circuit diagram of another embodiment of the inverter circuit.

Figure 12 is a circuit diagram showing a part of an embodiment of a static memory which employs the transistor of the present invention.

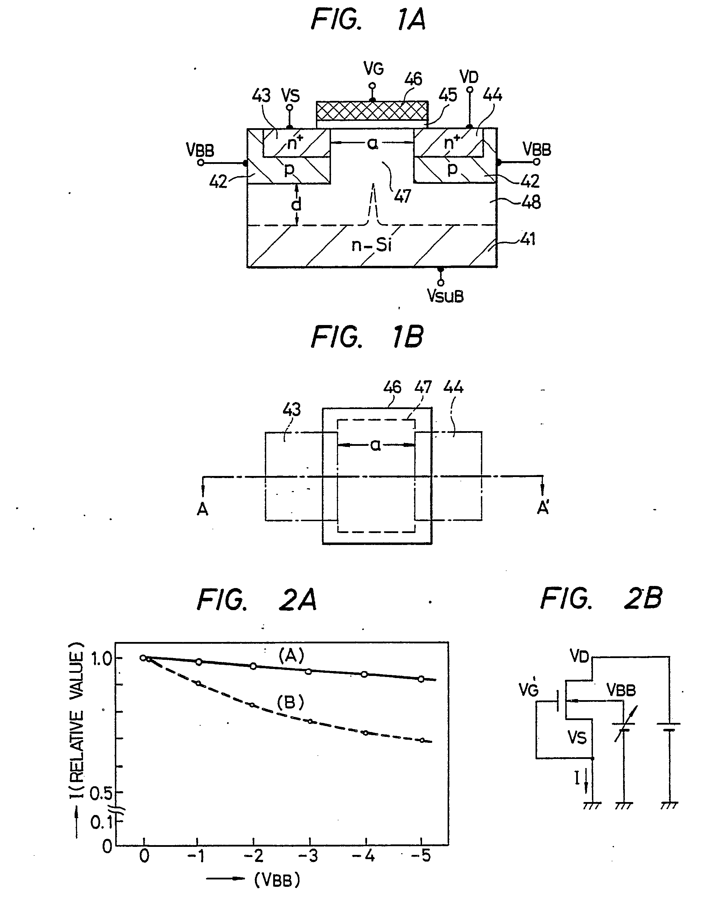

Figure 1A is a sectional view which shows an example of the device structure of a MOS transistor of small body effect according to the present invention. In the region of an n-type silicon substrate 41 having a low impurity concentration of $10^{14}$—$10^{15}$ cm$^{-3}$, which extends from the major surface thereof down to a depth of 3—4 μm, there is formed a p-type impurity region 42 (hereinbelow, briefly denoted as "p-well") the impurity concentration of which is $10^{15}$—$10^{16}$ cm$^{-3}$. Herein, however, the material of the n-type substrate appears in a partial region 47 of the major surface. The n-type region surrounded by the p-well shall be called the "opening". In those positions of the p-well 42 which oppose with the opening 47 interposed therebetween, n$^+$ layers 43 and 44 extending from the surface are formed, which serve as a source region and a drain region respectively. A gate oxide film 45 is formed in a manner to cover the opening 47, and is overlaid with a gate electrode 46 which is made of doped polycrystalline silicon or of a metal. Thus, one n-channel MOS transistor is constructed. Figure 1B is a plan view of the device shown in Figure 1A, and Figure 1A corresponds to section A—A' in Figure. 1B.

The device illustrated in Figures 1A and 1B is operated with the potential $V_{BB}$ of the p-well 42 fixed at the ground or a negative potential and the potential $V_{SUB}$ of the substrate 41 fixed at a positive potential, so that the well 42 and the substrate 41 are reverse-biased throughout the operation. While a depletion layer 48 is formed between the p-well 42 and the n-type silicon substrate 41 by the reverse bias voltage, it extends to be deeper on the side of the n-type substrate 41 because the impurity concentration of the n-type silicon substrate 41 is lower than that of the p-well 42. The depletion layer 48 is formed within the p-well opening 47 located between the source 43 and the drain 44. In a case where the width $a$ of the p-well opening 47 is smaller than double the depth $d$ of the depletion layer, namely, $2 \cdot d$, the interior of the p-well opening 47 underneath the gate is entirely depleted, with the result that a deep depletion layer corresponding to (depth of the p-well 42+depth $d$ of the depletion layer 48) is formed underneath the gate 46. Further, positive charges resulting from the ionization of the donor impurity of the n-type substrate exist within the depletion layer. Accordingly, when the aforementioned reverse bias voltage enough to form the depletion layer of depth $d$ is applied across the substrate 41 and the p-well 42 during the operation, the MOS transistor of the present structure comes to have a negative threshold voltage and be in the depletion mode.

Figure 2A shows the current characteristic of the device illustrated in Figures 1A and 1B. A method of measuring the characteristic is as depicted in Figure 2B. More specifically, variation in current I flowing between the drain and source of the transistor was measured by varying the applied voltage $V_{BB}$ to the p-well 42 with the drain potential $V_D$ and the source potential $V_S$ held fixed respectively. As apparent from Figure 2A, the current I flowing through the device of the embodiment is substantially constant irrespective of the voltage $V_{BB}$ applied to the well, and the body effect is hardly observed. For the sake of comparison, a broken line in Figure 2A illustrates an example of the current characteristic of a conventional depletion-mode MOS transistor in which n-type source, drain and channel regions are formed in the major surface of a p-type silicon substrate.

With the present device structure, the theshold voltage of the MOS transistor which determines the device current can be controlled by varying the impurity concentration of the n-type substrate region within the p-well opening. When the impurity concentration of the n-type substrate region is made higher, the threshold voltage increases in the negative direction, and a greater current flows.

In addition, with the present device, the depth of the depletion layer 48 extending into the p-well opening 47 is changed by varying the voltage which is applied across the n-type substrate 41 and the p-well 42. Therefore, the characteristic of the device somewhat changes depending upon the magnitude of this voltage.

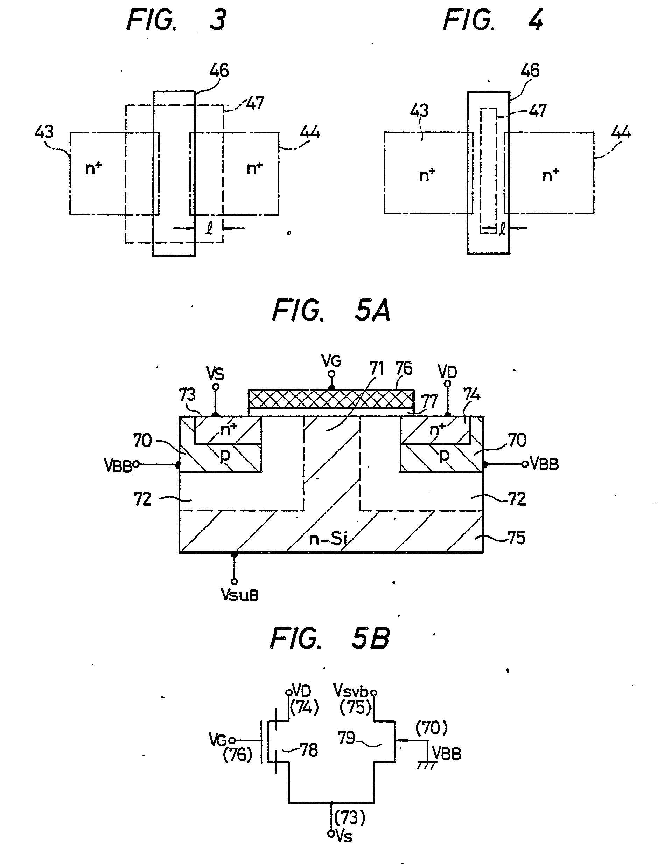

Figure 3 shows a plan view of an embodiment which differs from the embodiment of Figures 1A and 1B in the positions of source and drain regions. In the present embodiment, an n$^+$ layer 43 to function as the source and an n$^+$ layer 44 to function as the drain are formed in a manner to partly extend into the opening 47 of the p-well. The other ponts are the same as in Figures 1A and 1B, and a device having substantially the same characteristic is obtained.

Figure 4 shows still another embodiment. In this embodiment, an n$^+$ layer 43 to function as the source and an n$^+$ layer 44 to function as the drain are not exposed to the side surfaces of the opening 47 of the p-well, but they are included within the p-well in a manner to stand back from the side surfaces. Such a device is liable to be produced by the lateral diffusion of an impurity during the manufacturing process. It exhibits substantially the same characteristic as that of the device of Figures 1A and 1B, subject to the condition that the distance between the opening 47 and the source 43 or the drain 44. is short.

Figure 5A shows still another embodiment. In this embodiment, a p-well 70, a source region 73, a drain region 74, a gate 76, a gate oxide film 77, etc. are formed similarly to those of the example shown in Figure 1A. However, the width a of an opening 71, the impurity concentrations of the respective regions, and the value of the reverse bias voltage ($V_{BB}$—$V_{SUB}$) across the p-well 70 and a substrate 75 are selected so that the opening 71 of the p-well 70 may not be entirely depleted but that an n-type region where conduction electrons exist may be left in the central part thereof. For example, in a case where a p-well, being 4 μm deep and having an impurity concentration of $5 \times 10^{15}$ cm$^{-3}$, is grounded and where an n-type substrate having an impurity concentration of $5 \times 10^{14}$ cm$^{-3}$ has 5 V applied thereto, the interior of the opening of the p-well is not wholly depleted but the device structure as in the present embodiment is realized, subject to the condition that the width of the p-well opening is at least 10 μm. In addition, in a case where the impurity concentration of the n-type substrate is made $5 \times 10^{15}$ cm$^{-3}$, the device structure of the present embodiment is realized subject to the condition that the p-well opening is at least 5 μm wide.

Likewise to the device shown in Figures 1A and 1B, this MOS transistor has the characteristic of small body effect in the depletion mode, and the current controlled by the gate voltage flows between the source 73 and the drain 74. Since, however, the p-well opening 71 is not entirely depleted in this device, there is also current which flows from the n-type substrate 75, having a positive potential applied thereto, into the source 73 through the p-well opening 71. As shown in Figure 5B, an equivalent circuit of this MOS transistor is considered such that a depletion-mode MOS transistor 78 as shown in Figure 1A and a vertical junction type FET 79 having an n-channel are connected in parallel, the FET having the n-type substrate 75 as its drain, the p-well 70 as its gate and the n$^+$ layer 73 as its source. When such a device is used as the load, the load current flows through the two elements, so that the capability to charge the load capacitance is high and the operating speed of the circuit can be rendered high. The present device is cubically formed in such a manner that the vertical junction type FET is buried in under the gate electrode. Therefore, the load current supplying capability relative to the device area is great, and the device is capable of achieving a high density of integration.

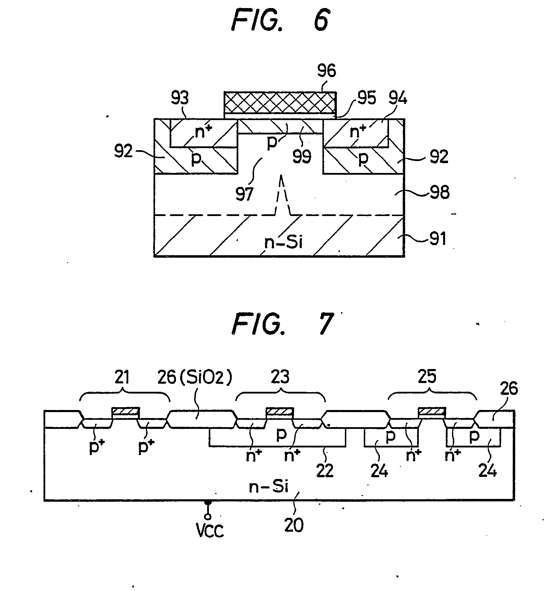

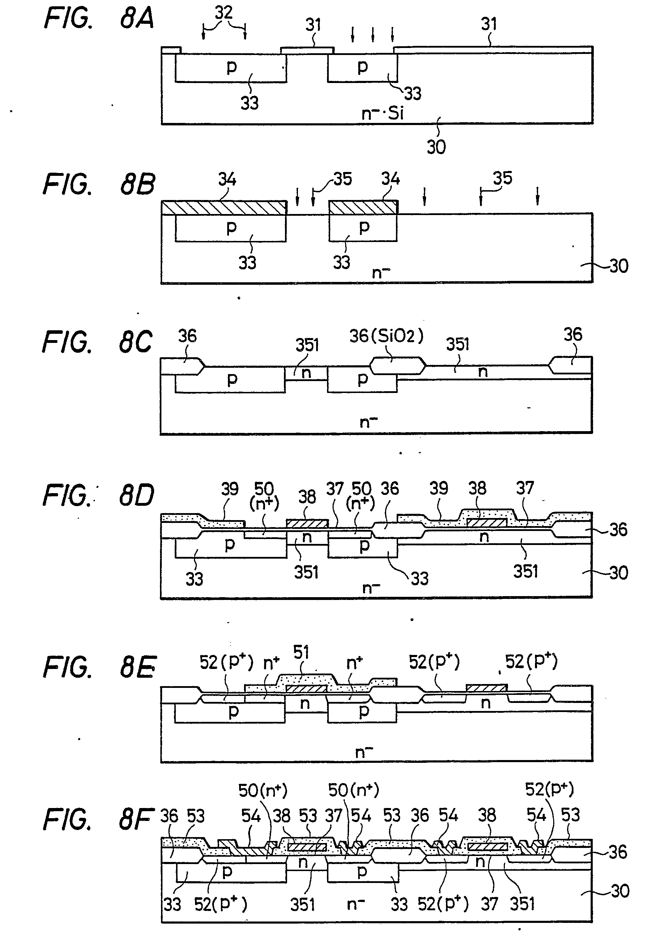

While all the embodiments thus far described have been the depletion-mode MOS transistors, an embodiment shown in Figure 6 concerns an enhancement-mode MOS transistor of small body effect. Likewise to the foregoing embodiment shown in Figures 1A and 1B, the device of the present embodiment is formed with a p-type well 92 in the major surface of an n-type silicon substrate 91 in a manner to leave an opening 97 behind and is provided with an n$^+$ layer 93 to serve as the source, an n$^+$ layer 94 to serve as the drain, a gate oxide film 95 and a gate electrode 96. The interior of the p-well opening 97 is entirely depleted, but a p-type impurity layer 99 is formed in the surface of the p-well opening 97 underneath the gate electrode 96 by ion implantation or the like in order to bring the threshold voltage of the transistor into one of the enhancement mode. With such device structure when the p-type impurity layer 99 becomes deeper than 0.5 μm, the body effect increases gradually. In order to eliminate the body effect, therefore, the p-type impurity layer 99 should desirably be made at most 0.5 μm deep and as shallow as possible.

A MOS transistor which has the characteristic of the enhancement mode and whose body effect is suppressed, can also be realized in such a way that, in the structure depicted in Figures 1A and 1B, the gate electrode 46 is formed of a material having a great work function, for example, p-type polycrystalline silicon at a high impurity concentration.

Each of the various foregoing MOS transistors with the body effect suppressed requires a well region which has the opposite conductivity type to that of the substrate. Accordingly, it can be readily formed on the same chip as that of a complementary MOS transistor circuit (hereinbelow, abbreviated to "CMOS circuit") which requires a similar well region.

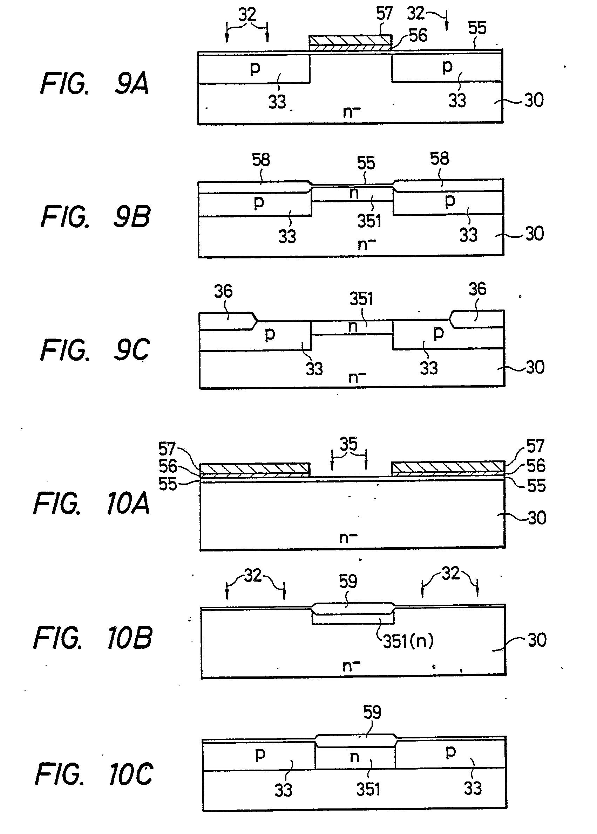

Figure 7 is a sectional view showing such an example. On an n-type Si substrate 20, a p-channel MOS transistor 21 is formed. In a p-well 22 within the n-type substrate, an n-channel MOS transistor 23 of the conventional structure is formed. Further, using a p-well 24 formed simultaneously with the p-well 22, an n-channel MOS transistor 25 of suppressed body effect which is similar to the transistor of Figures 1A and 1B is formed. Numeral 26 designates a thick SiO$_2$ film for isolating the elements. A circuit of high operating speed can be formed by this MOS transistor whose body effect is suppressed. Further, a circuit of low power dissipation can be formed by the CMOS circuit. By jointly employing the two in combination, therefore, a high performance MOS integrated circuit of high operating speed and low power dissipation can be constructed.

Figures 8A to 8F illustrate in detail a method of manufacturing still another embodiment in which the MOS transistor of suppressed body effect according to the present invention is combined with a CMOS circuit.

A pattern 31 of an SiO$_2$ film which is 0.5—1.0 μm thick is formed on those areas of the surface of an n-type substrate 30 having an impurity concentration of $10^{14}$—$10^{15}$ cm$^{-3}$ which corresponds to the opening of a p-well and under which no well is formed. Using the pattern as a mask, a p-type impurity such as boron 32 is ion-implanted under the condition of an ion dose of $10^{12}$—$10^{13}$ cm$^{-2}$. Thereafter, the impurity is thermally diffused at a high temperature of 1100—1200°C, to form the p-well 33 which is 3—4 μm deep (Figure 8A). Thereafter, the SiO₂ film 31 is removed, and only the p-well region is covered with a photoresist film 34. An n-type impurity such as phosphorus 35 is ion-implanted into the p-well opening and the other region than the p-well under the condition of an ion dose of $10^{11}$—$10^{13}$ cm⁻², thereby to set the impurity concentration of the p-well opening as well as the aforementioned other region at a desired value (Figure 8B). After removing the photoresist film 34, a field oxide film 36 having a thickness of 0.5—1.0 μm is formed by selective oxidation (Figure 8C). At this time, the ion-implanted n-type impurity of the p-well opening etc. diffuses by approximately 0.5—1.5 μm as indicated at numeral 351 (Figure 8C). Subsequently, a thin gate oxide film 37 having a thickness of 20—100 nm and gate electrodes 38 made of polycrystalline silicon or a metal are formed. In a case where a p-type region is formed in the surface corresponding to the p-well opening, the surface part is doped with a p-type impurity such as boron by the ion implantation or the like before the gate electrodes 38 are formed. Further, the other regions than regions for forming high concentration n-type regions are covered with a mask 39 such as a photoresist film, SiO₂ film and Si₃N₄ film, whereupon the n⁺ regions 50 are formed by the use of phosphorus or arsenic (Figure 8D). Subsequently, the mask 39 is removed. Using a mask 51 such as a photoresist film, SiO₂ film and Si₃N₄ film again, high concentration p⁺ regions 52 are formed (Figure 8E). The p⁺ regions become a region for leading out an electrode from the p-well, and also the source and drain of a p-channel transistor for constructing the CMOS circuit. Next, after removing the mask 51, a surface protective film 53 such as a PSG film is formed, electrode holes are provided, and electrodes 54 are formed. Then, the device is prepared for use in the usual way.

Figures 9A—9C illustrate another process which is employed instead of the process for forming the p-well and doping the p-well opening with the n-type impurity as explained with reference to Figures 8A—8C. A pattern consisting of an Si₃N₄ film 56 and a photoresist film 57 is formed on that area of the surface of the n-type silicon substrate 30 which corresponds to the opening to be formed, through an SiO₂ film 55 having a thickness of 20—100 nm. Using the pattern as a mask, the p-type impurity 32 is ion-implanted, whereupon it is thermally diffused to form the p-well 33 (Figure 9A). Subsequently, after removing the photoresist film 57, local oxidation is performed by employing the Si₃N₄ film 56 as a mask, thereby to form an SiO₂ film 58 having a thickness of 0.2—0.5 μm thick. Thereafter, the Si₃N₄ film 56 is removed, and the n-type impurity 35 is ion-implanted. Thus, the p-well opening can be doped with n-type impurity in self-alignment· fashion without any increased photoresist step (Figure 9B). Thereafter, the SiO₂ film 58 is removed, and the field SiO₂ film 36 is

formed by the same step as in Figure 8C (Figure 9C). At this time, the n-type impurity of the p-well opening is diffused to be 0.5—1.5 μm deep, so that the n-type region 351 is formed. Subsequently, the n⁺ regions are formed by a process similar to that explained with reference to Figures 8D, 8E and 8F. Then, the MOS transistor is completed for use.

Figures 10A—10C illustrate still another process for forming the p-well and the n-type impurity layer within the p-well opening. First, an SiO₂ film 55, an Si₃N₄ film 56 and a photoresist film 57 which are 20—100 nm thick are stacked on the substrate 30. Subsequently, the Si₃N₄ film 56 and the photoresist film 57 in an area corresponding to the p-well opening to be formed are removed and the n-type impurity 35 is ion-implanted (Figure 10A). Subsequently, after removing the photoresist film 57, local oxidation is performed by employing the Si₃N₄ film 56 as a mask, to form an SiO₂ film 59 having a thickness of 0.1—0.4 μm, and after removing the Si₃N₄ film 56, the p-type impurity 32 is ion-implanted by employing the SiO₂ film 59 as a mask (Figure 10B). Thereafter, the p-well 33 and the n-type region 351 which are 3—4 μm deep are formed by thermal diffusion at a high temperature (Figure 10C). With this method of production, the n-type impurity layer within the p-well becomes substantially equal in depth to the p-well. Thereafter, the n⁺ layers to serve as the source and the drain are formed. The process therefor is similar to that explained with reference to Figures 8D, 8E and 8F, and is not repeated.

As set forth above, the MOS transistors of small body effect can be achieved in accordance with the present invention. Any of these transistors can produce the load current of the constant current characteristic which hardly changes even when the source potential has changed. Therefore, when applied to various parts of integrated circuits, the MOS transistors can provide integrated circuits of high operating speed. In general, they are used as loads for deriving outputs from logic networks.

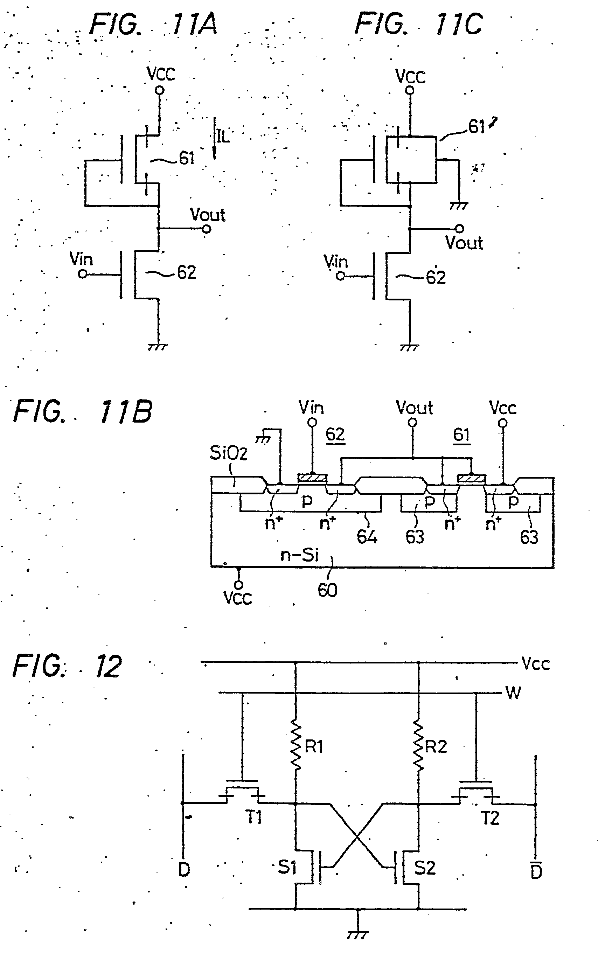

Figure 11A typically illustrates an example in which the MOS transistor is applied to an inverter circuit. The source-gate common end of a depletion-mode MOS transistor 61 of small body effect as illustrated in Figure 1A is connected to the drain of an enhancement-mode MOS transistor 62 whose source is earthed. The connection point is used as an output terminal, while the gate of the enhancement-mode MOS transistor 62 is used as an input terminal. A positive voltage source $V_{cc}$ is connected to the drain of the depletion-mode MOS transistor 61. As apparent from a sectional view of Figure 11B, the depletion-mode MOS transistor 61 is disposed at the position of a p-well 63 having an opening. On the other hand, the enhancement-mode MOS transistor 62 is disposed in a p-well 64 formed simultaneously with the p-well 63. The voltage source $V_{cc}$ is connected to an n-type substrate 60, and both the p-wells 63 and 64 are grounded.

By way of example, when the voltage $V_{In}$ of the input terminal has become a low level and the MOS transistor 62 being a driver has turned "off", stray capacitance coupled to the output terminal is charged through the depletion-mode MOS transistor 61 being a load, with the result that an output voltage $V_{Out}$ rises. Then, the operation ends. Unlike the conventional depletion-mode MOS transistor, the MOS transistor 61 employed in the present example allows a load current $I_L$ to flow which is substantially constant even when the output voltage $V_{Out}$, namely, the source potential of the MOS transistor 61 rises. Therefore, the load capacitance is rapidly charged.

Shown in Figure 11C is a circuit diagram of an E/D MOS inverter circuit in which the aforementioned depletion-mode MOS transistor 61 is replaced with a depletion-mode MOS transistor 61' as shown in Figure 5A. With this MOS transistor 61', charging current flows also from the n-type substrate 60 to the load through the p-well opening, so that an inverter circuit of faster operation can be realized.

In the above, two examples of the inverter circuits have been described. Generally speaking, it is a logic network that is connected in the place of the enhancement-mode MOS transistor 62. The depletion-mode MOS transistor 61 or 61' is driven by the logic network as the load thereof, and output signals of high speed can be provided from the output terminal.

Figure 12 shows an example in which the MOS transistor of the present invention is applied to a transfer gate. In this example, the MOS transistor of the present invention as shown in Figure 1A is employed for each of the transfer gates T1 and T2 of a memory cell in a static MOS-RAM. In the figure, symbol $V_{CC}$ denotes a power source line, symbol W a word line, symbols D and $\overline{D}$ data lines, symbols R1 and R2 resistors, and symbols S1 and S2 switching MOS transistors.

The embodiments described may be altered without departing from the scope of the present invention. For example, while only the n-channel MOS transistors have been referred to in the embodiments, the present invention is also applicable to p-channel MOS transistors.

**Claims**

1. An insulated gate field effect transistor comprising a semiconductor substrate (41) of a first conductivity type, at least one well region (42) of a second conductivity type in the substrate, a part of the at least one well region (42) being exposed at a surface of the substrate, source and drain regions (43, 44) of the first conductivity type within the at least one well region (42), such that the source and drain regions (43, 44) contact the well region (42) at a part thereof spaced from the surface of the substrate, and are exposed at the surface of the substrate, there being an insulating layer (45) on the surface of the substrate extending between the source and drain regions (43, 44), and a gate electrode (46) on the insulating layer (45),

characterised in that:

the well region (42) has an opening (47) reaching the surface between the source and drain region (43, 44), which opening contains semiconductor material of the first conductivity type.

2. An insulated gate field effect transistor according to claim 1, wherein the semiconductor material of the first conductivity type in the opening (47) is part of the substrate (41).

3. An insulated gate field effect transistor according to claim 1 or claim 2, wherein the well region (42) contacts parts of the source and drain regions (43, 44) spaced from the parts of those regions (43, 44) between which the opening (47) extends, so that the semiconductor material on the opening (47) contacts the source and drain regions.

4. An insulated gate field effect transistor according to claim 1 or claim 2, wherein the well region (42) encloses the source and drain regions (43, 44) within the substrate (41).

5. An insulated gate field effect transistor according to any one of claims 1 to 4, wherein said well region (42) has an impurity concentration higher than that of the semiconductor substrate (41).

6. An insulated gate field effect transistor according to any one of the preceding claims wherein an impurity layer (99) of the second conductivity type is provided in the opening (97) between the insulating layer (95) and the material of the first conductivity type in order to bring the threshold voltage of the transistor into one of the enhancement modes.

7. An insulated gate field effect transistor according to claim 6 wherein the impurity layer has a thickness of not more than 0.5 μm.

8. An insulated gate field effect transistor according to any one of the preceding claims, having bias means adapted to set potentials of the substrate (41) and the well region (42) such that a junction between the substrate (41) and the well region (42) is reverse-biased.

9. An insulated gate field effect transistor according to claim 8, wherein the bias means is adapted to generate a depletion layer in all the openings (47).

10. An insulated gate field effect transistor according to claim 8, wherein the bias means is adapted to generate a depletion layer in the peripheral regions of the opening (47) between the source and drain regions.

11. An insulated gate field effect transistor according to any one of the preceding claims, provided in the same semiconductor chip with a complementary MOS circuit.

12. An insulated gate field effect transistor according to any one of the preceding claims, wherein said gate electrode (46) and said source region are electrically connected.

13. An insulated gate field effect transistor according to claim 12, wherein said drain region is connected to a power source, said transistor is connected to a logic network at a common end of the source region and the gate electrode (46), and said common end is used as an output terminal.

**Revendications**

1. Transistor à effet de champ à grille isolée comportant un substrat semiconducteur (41) possèdant un premier type de conductivité, au moins une région de puits (41) possèdant un second type de conductivité dans le substrat, une partie d'au moins cette région de puits (42) étant dégagée au niveau de la surface du substrat, une région de source et de drain (43, 44) possède le premier type de conductivité et située dans au moins ladite région de puits (42) de telle sorte que les régions de source et de drain (43, 44) contactent la région de puits (42) dans une partie de cette dernière qui est distance de la surface du substrat et sont exposées au niveau de la surface du substrat, une couche isolante (45) située à la surface du substrat s'étendant entre les régions de source et de drain (43, 44), et une électrode de grille (46) située sur la couche isolante (45), caractérisé en ce que la région de puits (42) possède une ouverture (47) atteignant la surface située entre les régions de source et de drain (43, 44), laquelle ouverture contient un matériau semiconducteur possèdant le premier type de conductivité.

2. Transistor à effet de champ à grille isolée selon la revendication 1, dans lequel le matériau semiconducteur possèdant le premier type de conductivité dans l'ouverture (47) fait partie du substrat (41).

3. Transistor à effet de champ à grille isolée selon la revendication 1 ou 2, dans lequel la région de puits (42) contacte des parties des régions de source et de drain (43, 44) qui sont distantes des parties des régions (43, 44), entre lesquelles l'ouverture (47) s'étend, de sorte que le matériau semiconducteur présent dans l'ouverture (47) contacte les régions de source et de drain.

4. Transistor à effet de champ à grille isolée selon la revendication 1 ou 2, dans lequel la région de puits (42) en serre les régions de source et de drain (43, 44) à l'intérieur du substrat (41).

5. Transistor à effet de champ à grille isolée selon l'une quelconque des revendications 1 à 4, dans lequel ladite région de puits (42) possède une concentration en impuretés qui est supérieure à celle du substrat semiconducteur (41).

6. Transistor à effet de champ à grille isolée selon l'une quelconque des revendications précédentes, dans lequel une couche d'impuretés (99) possèdant le second type de conductivité est prévue dans l'ouverture (97) entre la couche isolante (95) et le matériau possèdant le premier type de conductivité, de manière à amener la tension de seuil du transistor à une valeur correspondant au mode d'enrichissement.

7. Transistor à effet de champ à grille isolée selon la revendication 6, dans lequel la couche d'impuretés possède une épaisseur supérieure à 0,5 µm.

8. Transistor à effet de champ à grille isolée selon l'une quelconque des revendications précédentes, possèdant les moyens de polarisation aptes à régler des potentiels du substrat (41) et de la région de puits (42) de manière qu'une jonction entre le substrat (41) et la région de puits (42) est polarisée à l'inverse.

9. Transistor à effet de champ à grille isolée selon la revendication 8, dans lequel les moyens de polarisation sont adaptés à produire une couche d'appauvrissement dans l'ensemble de l'ouverture (47).

10. Transistor à effet de champ à grille isolée selon la revendication 8, dans lequel les moyens de polarisation sont adaptés pour produire une couche d'appauvrissement dans les régions périphériques de l'ouverture (47) entre les régions de source et de drain.

11. Transistor à effet de champ à grille isolée selon l'une quelconque des revendications précédentes, prévu dans la même microplaquette à semiconducteur qu'un circuit MOS complémentaire.

12. Transistor à effet de champ à grille isolée selon l'une quelconque des revendications précédentes, dans lequel ladite électrode de grille (46) et ladite région de source sont raccordées électriquement.

13. Transistor à effet de champ à grille isolée selon la revendication 12, dans lequel ladite région de drain est raccordée à une source d'alimentation en énergie, ledit transistor est raccordée à un réseau logique au niveau d'une extrémité commune de la région de source et de l'électrode de grille (46), et ladite extrémité commune est utilisée en tant que borne de sortie.

**Patentansprüche**

1. Feldeffekttransistor mit isoliertem Gate mit einem Halbleitersubstrat (41) eines ersten Leitfähigkeitstyps, mit wenigstens einem in dem Substrat angeordneten Wannengebiet (42) des zweiten Leitungstyps, wobei ein Teil dieses Wannengebietes (42) an des Oberfläche des Substrates freiliegt und in diesem Wannengebiet (42) Source- und Draingebiete (43, 44) des ersten Leitungstyps so angeordnet sind, daß die Source- und Draingebiete (43, 44), das Wannengebiet (42) in einem Teil berühren, der von der Oberfläche des Substrates entfernt ist, und zue Oberfläche des Substrates freiliegen, wobei eine Isolationsschicht (45) auf der Oberfläche des Substrates sich zwischen den Source- und Draingebieten (43, 44) erstreckt und eine Gate-Elektrode (46) auf der Isolationsschicht (45) angeordnet ist, dadurch gekennzeichnet, daß das Wannengebiet (42) zwischen dem Source- und dem Draingebiet (43, 44) eine zur Oberfläche reichende Öffnung (47) aufweist, welche Halbleitermaterial des ersten Leitungstyps enthält.

2. Feldeffekttransistor mit isoliertem Gate nach Anspruch 1, wobei das Halbleitermaterial des ersten Leitungstypes in der Öffnung (47) ein Teil des Substrates (41) ist.

3. Feldeffekttransistor mit isoliertem Gate nach Anspruch 1 oder 2, wobei das Wannengebiet (42) Teile der Source- und Draingebiete (43, 44) berührt, welche von den Teilen jener Gebiete (43, 44), zwischen welchen sich die Öffnung (47) erstreckt, im Abstand angeordnet sind, so daß das Halbleitermaterial in der Öffnung (47) die Source- und Draingebiete berührt.

4. Feldeffekttransistor mit isoliertem Gate nach Anspruch 1 oder 2, wobei das Wannengebiet (42) die Source- und Draingebiete (43, 44) innerhalb des Substrates (41) umgibt.

5. Feldeffekttransistor mit isoliertem Gate nach einem der Ansprüche 1 bis 4, wobei das Wannengebiet (42) eine höhere Störstellenkonzentration als das Halbleitersubstrat (41) besitzt.

6. Feldeffekttransistor mit isoliertem Gate nach einem der vorangehenden Ansprüche, wobei eine Störstellenschicht (99) des zweiten Leitungstyps in der Öffnung (97) zwischen der Isolationsschicht (95) und dem Material des ersten Leitungstyps angeordnet ist, um die Schwellspannung des Transistors auf eine solche des Anreicherungsmodes zu bringen.

7. Feldeffekttransistor mit isoliertem Gate nach Anspruch 6, wobei die Störstellenschicht eine Dicke von nicht mehr als 0,5 μm besitzt.

8. Feldeffekttransistor mit isoliertem Gate nach einer der vorangehenden Ansprüche, wobei eine Vorspannungseinrichtung vorgesehen ist, die geeignet ist, die Potentiale des Substrates und des Wannengebietes so festzulegen, daß eine zwischen dem Substrat (41) und dem Wanngengebiet (42) vorhandene Grenzschicht in Sperrichtung vorgespannt ist.

9. Feldeffekttransistor mit isoliertem Gate nach Anspruch 8, wobei die Vorspannungseinrichtung geeignet ist, in der gesamten Öffnung (47) eine Verarmungsschicht zu erzeugen.

10. Feldeffekttransistor mit isoliertem Gate nach Anspruch 8, wobei die Vorspannungseinrichtung geeignet ist, in der peripheren Gebiete der Öffnung (47) zwischen den Source- und Draingebieten eine Verarmungsschicht zu erzeugen.

11. Feldeffekttransistor mit isoliertem Gate nach einem der vorangehenden Ansprüche, der auf dem gleichen Halbleiterchip zusammen mit einerm komplementären MOS-Schaltung vorgesehen ist.

12. Feldeffekttransistor nach einem der vorangehenden Ansprüche, wobei die Gate-Elektrode (46) und das Sourcegebiet elektrisch miteinander verbunden sind.

13. Feldeffekttransistor nach Anspruch 12, wobei das Draingebiet mit einer Spannungsversorgung verbunden ist, der Transistor mit einem logischen Netzwerk an einem gemeinsamen Ende des Sourcegebietes und der Gate-Elektrode (46) verbunden ist, und wobei das gemeinsame Ende als Ausgangsanschluß verwendet wird.

## FIG. 1A

## FIG. 1B

## FIG. 2A

## FIG. 2B

1

## FIG. 3

## FIG. 4

## FIG. 5A

## FIG. 5B

## FIG. 6

## FIG. 7

**0 070 744**

FIG. 8A

FIG. 8B

FIG. 8C

FIG. 8D

FIG. 8E

FIG. 8F

4

FIG. 9A

FIG. 9B

FIG. 9C

FIG. 10A

FIG. 10B

FIG. 10C

## FIG. 11A

## FIG. 11C

## FIG. 11B

## FIG. 12